# EUROPEAN PATENT APPLICATION

(11) **EP 4 597 549 A1**
(43) Date of publication of application: **06.08.2025**
(21) Application number: 24212722.3
(22) Date of filing: 13.11.2024
(51) Int. Cl.: H01L 21/48, H01L 23/427, H01L 23/473, H01L 23/40

(54) **IMMERSION COOLING DEVICE**

(30) Priority: 02.02.2024 TW 113104098
(71) Applicant: Cooler Master Co., Ltd., Taipei City 114065 (TW)
(72) Inventor: SAHOO, VENKATA RAMAN, 114065 Taipei City (TW)
(74) Representative: Grünecker Patent- und Rechtsanwälte PartG mbB

(57) **Abstract**

An immersion cooling device for dissipating heat includes a base portion having a heat absorbing surface and a heat dissipating surface, a fin portion that is arranged on the heat dissipating surface of the base portion, and a covering portion that forms a vapor chamber around the fin portion on the base portion. The covering portion can include a liquid inlet channel and a liquid outlet channel that are connected to the vapor chamber. Further, the fin portion can include an inlet section that is located adjacent to the liquid inlet channel and an outlet section that is located adjacent to the liquid outlet channel, and a cavity that is formed over the outlet section.

## Description

### TECHNICAL FIELD

The present disclosure is related to the field of heat dissipation devices, in particular an immersion cooling device having a cavity.

### BACKGROUND

With the rapid development of technology, the computing power of various electronic components has also increased dramatically, and at the same time, a large amount of heat is generated. In order to help protect electronic components from damage from high heat, as well as optimize performance of the components, heat dissipation devices can be installed on the electronic components to dissipate excess heat.

Electronic components are often cooled by a two-phase liquid cooling system to maintain their performance and service life. The two-phase liquid cooling system refers to a liquid cooling system, in which the liquid cooling fluid absorbs the heat generated by the electronic components and produces a phase change, so that the liquid cooling fluid evaporates into a gaseous cooling fluid that helps to carry away the heat generated by the electronic components.

### SUMMARY

The invention is as defined in the appended claims.

Aspects of the disclosure provide an immersion cooling device for dissipating heat. The immersion cooling device includes a base portion having a heat absorbing surface and a heat dissipating surface. Further, a fin portion that is arranged on the heat dissipating surface of the base portion and a covering portion that forms a vapor chamber around the fin portion on the base portion. The covering portion includes a liquid inlet channel and a liquid outlet channel that are connected to the vapor chamber. The fin portion further includes an inlet section that is located adjacent to the liquid inlet channel and an outlet section that is located adjacent to the liquid outlet channel, and a cavity that is formed over the outlet section.

In an embodiment, the outlet section can include a first height away from the inlet section and a second height adjacent to the inlet section, where the first height is smaller than the second height. Further, the outlet section can be contoured to include an inclined structure. In an embodiment, the outlet section can include a generally planar inclined surface having an incline angle of greater than 0.5 degree and smaller than 5 degrees.

In some embodiments, the outlet section can have various configurations, such a stepped or ladder structure. Further, the outlet section can be a multi-groove structure or an inclined multi-groove structure. In an embodiment, the outlet section can have a horizontal length of 17.5 mm, and the fin portion can have a horizontal length of 35 mm.

In an embodiment, the fin portion can include multiple fins having a thickness of 0.11 mm and a spacing of 0.11 mm between each other.

In an embodiment, the covering portion can include an internal circulation channel having a first end and a second end connect to the vapor chamber at a location adjacent to the inlet section and a location adjacent to the outlet section, respectively. In an embodiment, the internal circulation channel can include a bottom surface facing the heat dissipating surface. A distance between the bottom surface at the first end and the heat dissipating surface is greater than a distance between the bottom at the second end and the heat dissipating surface.

In an embodiment, the covering portion can further include an inner surface and at least one microfluidic channel, the inner surface faces the heat dissipating surface, the at least one microfluidic channel is concave inward from the inner surface, the first end of the internal circulation channel connects to the vapor chamber at the location close to the inlet section via the liquid inlet channel, and the second end of the internal circulation channel connects to the vapor chamber at the location close to the outlet section via the at least one microfluidic channel. In an embodiment, the covering portion further includes a plurality of piercing structures close to the at least one microfluidic channel, the plurality of piercing structures protrudes from the inner surface of the covering portion.

In an embodiment, the immersion cooling device further includes a side cover, the covering portion includes a at least one processing channel connected to the internal circulation channel, and the at least one side cover is configured to cover the at least one processing channel at a side that is away from the internal circulation channel.

In an embodiment, the cavity can have a first volume, the outlet section can have a second volume, and a ratio between the first volume and the second volume can be 1.213.

### BRIEF DESCRIPTION OF DRAWINGS

Aspects of the present disclosure can be understood from the following detailed description when read with the accompanying figures. It is noted that, in accordance with the standard practice in the industry, various features are not drawn to scale. In fact, the dimensions of the various features may be increased or reduced for clarity of discussion.
Fig. 1 illustrates a three-dimensional view of an immersion cooling device 10 according to one embodiment of the disclosure.
Fig. 2 illustrates exploded view of the immersion cooling device 10 as in Fig. 1.
Fig. 3 illustrates a three-dimensional view of the covering portion 13 of the immersion cooling device 10 as in Fig. 1.
Fig. 4 illustrates a three-dimensional view of the base portion 11 and fin portion 12 of the immersion cooling device 10 as in Fig. 1.
Fig. 5 illustrates a cross section view of the immersion cooling device 10 as in Fig. 1 along the 5-5 line.
Fig. 6 illustrates a cross-section view of the immersion cooling device 10 along the 6-6 cut line of Fig. 1.
Fig. 7 illustrates a partially enlarged cross-section view of the immersion cooling device 10 shown in Fig. 1.
Fig. 8 illustrates a cross-section view of the vapor chamber S in Fig. 1 when air bubbles are generated.
Fig. 9 illustrates a cross-section view of the vapor chamber S when air bubbles are pierced and flowed into microfluidic channels 135.
Figure 10 illustrates a cross-section view the vapor chamber 10 and the flow of the cooling fluid vapor during operation of the immersion cooling device 10.
Fig. 11 illustrates a cross-section view of an immersion cooling device 10A according to a second embodiment of the disclosure.
Fig. 12 illustrates a cross-section view of an immersion cooling device 10B according to a third embodiment of the disclosure.

### DETAILED DESCRIPTION

Detailed descriptions and technical contents of the disclosure are illustrated below in conjunction with the accompanying drawings. However, it is to be understood that the descriptions and the accompanying drawings disclosed herein are merely illustrative and exemplary and not intended to limit the scope of the disclosure.

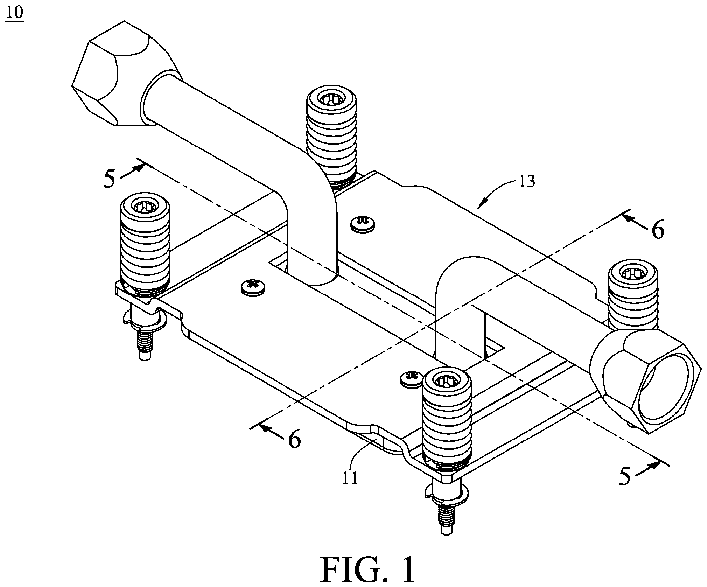

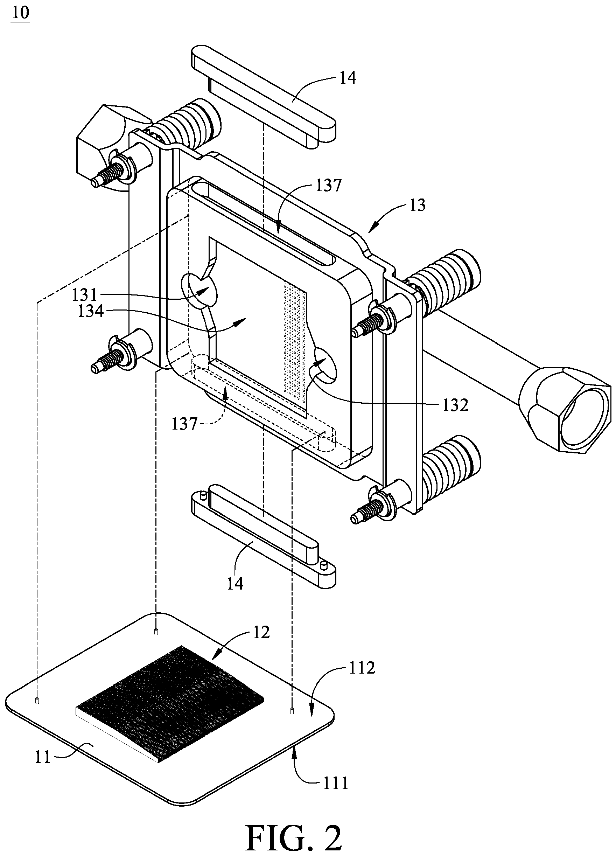

Fig. 1 illustrates an immersion cooling device 10 according to one embodiment of the present disclosure. Figs. 2-5 are various different views of the immersion cooling device 10 as in Fig. 1. Fig. 2 illustrates an exploded view of the immersion cooling device 10 as in Fig. 1. The immersion cooling device 10 can be a water-cooling plate which can be thermal coupled to a heat source (not shown). As shown, the immersion cooling device 10 can include a base portion 11, a fin portion 12, and a covering portion 13.

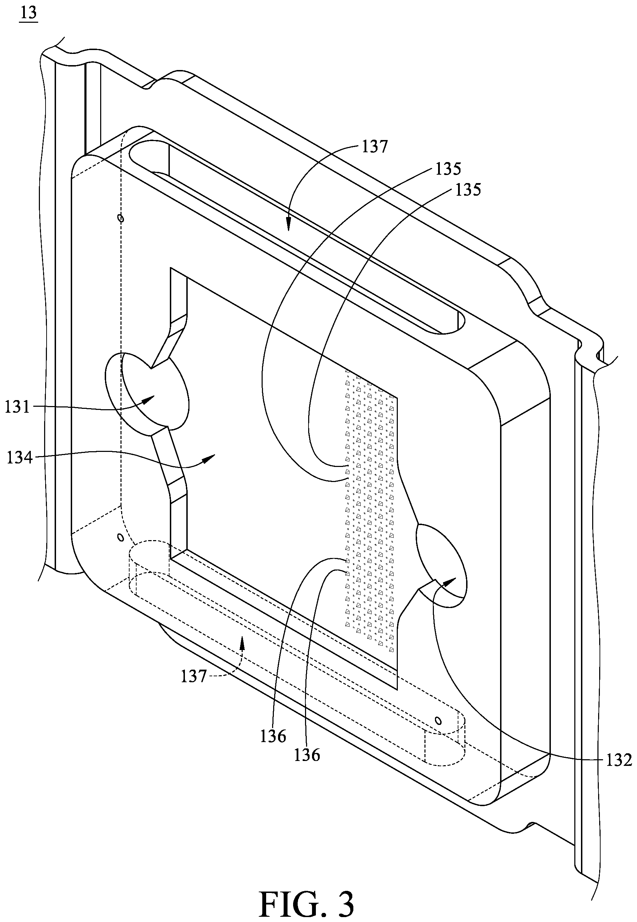

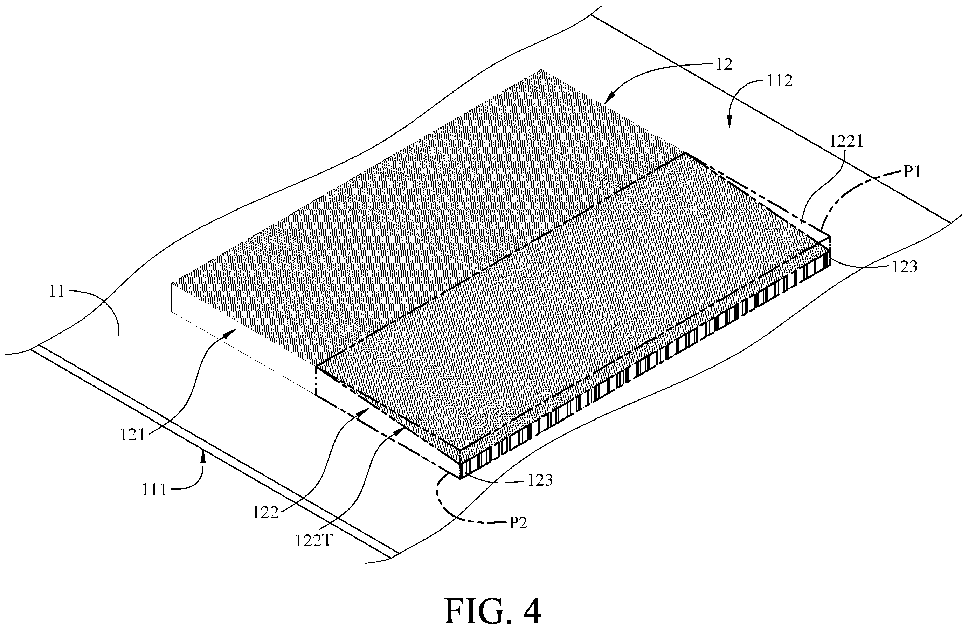

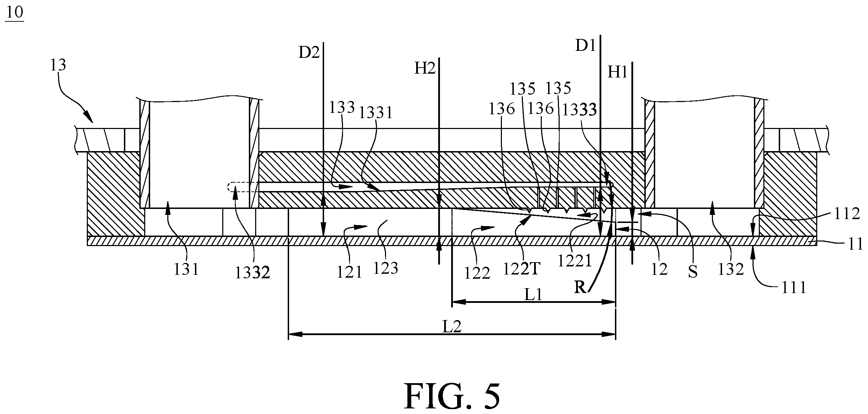

Fig. 3 illustrates a three-dimensional view of the covering portion 13 of the immersion cooling device 10 as in Fig. 1. Fig. 4 illustrates a three-dimensional view of the base portion 11 and fin portion 12 of the immersion cooling device 10 as in Fig. 1. Fig. 5 illustrates a cross section view of the immersion cooling device 10 as in Fig. 1 along the 5-5 line.

The base portion 11 includes a heat absorbing surface 111 and a heat dissipating surface 112. The heat dissipating surface 112 is on the opposite side of the heat absorbing surface 111. The heat absorbing surface 111 can be used to absorb the heat of the heat source and transfer to the heat dissipating surface 112. The fin portion 12 protrudes from the heat dissipating surface 112.

The covering portion 13 is arranged on the base portion 11 and at least partially concave inward from a side that faces the base portion 11 to form a vapor chamber S (as shown in Fig. 5). As illustrated in Fig. 3, the covering portion 13 has a region concaved inward to form a liquid inlet channel 131, a liquid outlet channel 132, and an inner surface 134. Multiple microfluidic channels 135 and multiple piercing structures 136 are disposed on the inner surface 134 of the covering portion 13. The vapor chamber S accommodates the fin portion 12 and a cooling fluid (not shown). The cooling fluid can be any suitable fluid for carrying heat away from the electronic component. For example, the cooling fluid can be refrigerant or water. The liquid inlet channel 131 and the liquid outlet channel 132 both connect to the vapor chamber S.

Referring to Fig. 4, the fin portion 12 can include an inlet section 121 and a outlet section 122. The inlet section is position adjacent to the liquid inlet channel 131, and the outlet section is positioned adjacent to the liquid outlet channel 132. For example, the inlet section 121 is located on the same side as the liquid inlet channel 131 in the vapor chamber S and the outlet section 122 is located on the same side as the liquid outlet channel 132 in the vapor chamber S.

Referring to Fig. 5, the outlet section 122 can be configured to have a cavity 1221 between a top side 122T of outlet section 122 and the inner surface 134 of the covering portion 13. As shown, the outlet section 122 can have fins that are made to form a top side 122T having planar ramp-like shape that extends towards the heat dissipating surface 112 from a height H2 to a height H1. As shown, the height H1 is smaller than height H2 and is located away from the liquid inlet channel 131. That is, the top side 122T of the outlet section 122 is sloped away from the inlet section 121. When the cooling fluid evaporates after absorbing the heat from the heat dissipating surface 112, air bubbles (not shown) can be formed in the fin portion 12. With the configuration of the outlet section 122, the air bubbles in the fin portion 12 can be reduced as the air bubbles are able to exit the fin portion 12 faster.

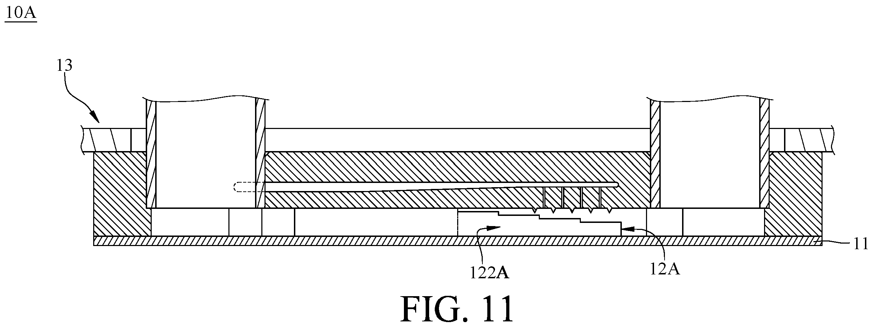

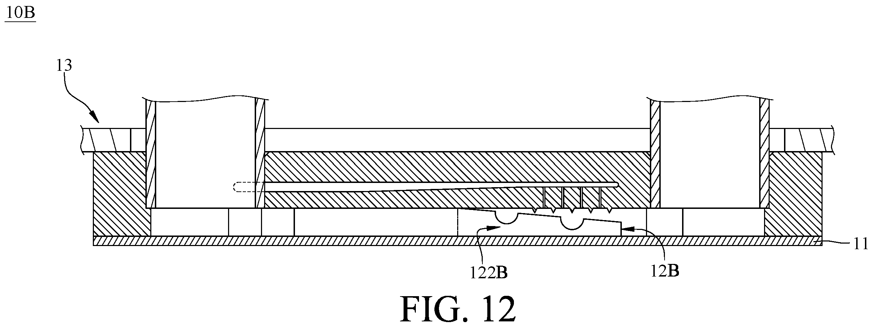

During operation of the immersion cooling device 10, accumulation of the air bubbles can be reduced around the outlet section 122, and a flow resistance and pressure drop of the cooling fluid can also be reduced to improve the heat dissipation efficiency. Of course, while in this exemplary embodiment the outlet section 122 is shown as having a generally planar ramp-like shape, it should be understood that many other configurations, such as those shown below with respect to Figs. 11 and 12, are also possible to accomplish the improved heat dissipation efficiency. Additionally, the cavity 1221 between a top side 122T of the outlet section 122 and the inner surface 134 of the covering portion 13 may be formed entirely or in part by an indent in the inner surface 134 of the covering portion 13.

Refer to Fig. 5, the outlet section 122 has an inclination angle R. In one embodiment, the inclination angle R can be greater than or equal to 0.5 degrees and less than or equal to 5 degrees. The outlet section 122 can have a horizontal length L1, and the fin portion can have a horizontal length L2. In one embodiment, the horizontal length L1 can be 17.5 mm and the horizontal length L2 can be 35 mm.

As illustrated in Fig. 4, the cavity 1221 can have a first volume P1. The outlet section 122 can have a second volume P2. In an exemplary embodiment, the first volume P1 can be 876.88 cubic millimeters and the second volume P2 can be 1063.69 cubic millimeters, and the ratio of the second volume P2 to the first volume P1 can be 1.213. That is to say, the ratio of the volume of the outlet section 122 to the volume of the cavity 1221 can be 1.213. The specific volumes of the outlet section 122 and the cavity 1221 can be modified to suit the specific application of the immersion cooling device and to accomplish the improved heat dissipation efficiency.

The covering portion 13 can also include an internal circulation channel 133. A first end 1332 of the internal circulation channel 133 connects with the liquid inlet channel 131. A second end 1333 of the internal circulation channel 133 disposed in the vapor chamber S adjacent to the liquid outlet channel 132. The internal circulation channel 133 has a bottom surface 1331 that is close to the heat dissipating surface 112. The internal circulation channel 133 has a distance D1 between the bottom surface 1331 close to the second end 1333 and the heat dissipating surface 112. The internal circulation channel 133 has a distance D2 between the bottom surface 1331 close to the first end 1332 and the heat dissipating surface 112. The distance D1 is greater than the distance D2. That is, the bottom surface 1331 of the internal circulation channel 133 is sloped towards the liquid inlet channel 131. In this way, after the air bubbles produced by the evaporation of the cooling fluid condense into a liquid state, they can flow more smoothly in the internal circulation channel 133 from the second side 1333 to the first side 1332.

The microfluidic channels 135 are concave inward from the inner surface 134. The first end 1332 of the internal circulation channel 133 is connected to the vapor chamber S through the liquid inlet channel 131. For example, the first end 1332 of the internal circulation channel 133 is connected to the inlet channel 131 so that the cooling fluid flows from the internal circulation channel 133 through the inlet channel 131 and then flows back into the accommodating chamber S. The second end 1333 of the internal circulation channel 133 is connected to the vapor chamber S through the microfluidic channels 135. In this way, the cooling fluid can flow into the vapor chamber S from the liquid inlet channel 131, and into the internal circulation channel 133 through the microfluidic channels 135, and then flow back into the accommodating chamber S through the liquid inlet channel 131 from the internal circulation channel 133, as to complete the cooling cycle.

The piercing structures 136 are adjacent to the microfluidic channels 135 and protrude from the inner surface 134. The piercing structures 136 can be used to puncture the air bubbles produced by the evaporation of the cooling fluid to further reduce the resistance and pressure drop of the cooling fluid flow.

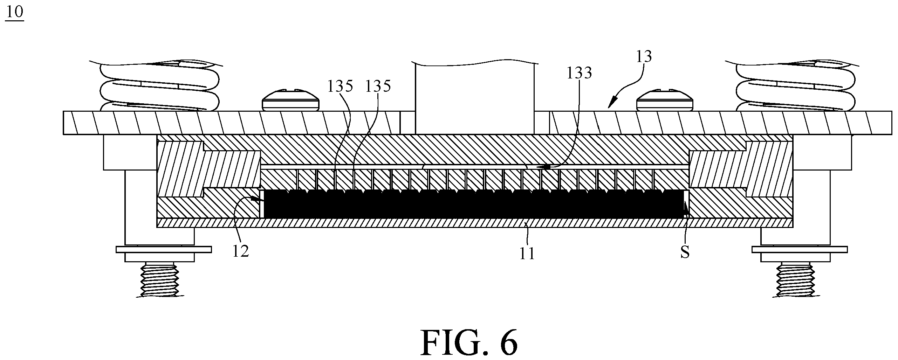

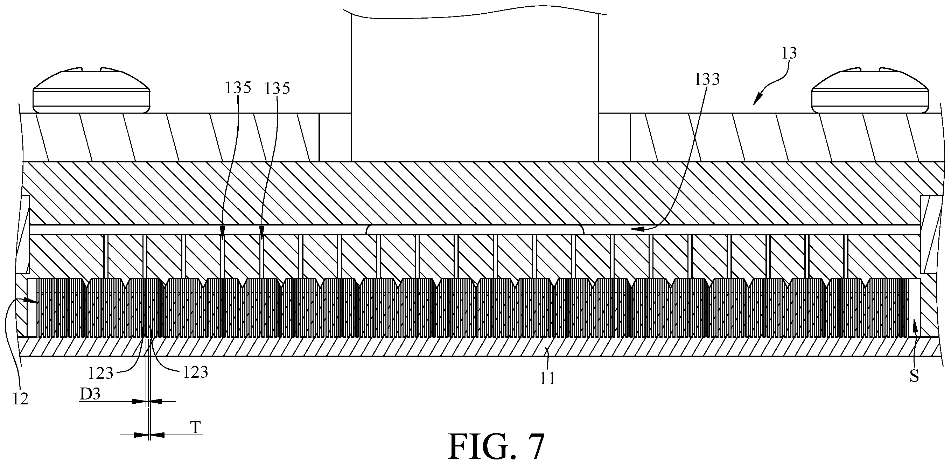

Referring to Figs. 6 and 7. Fig. 6 illustrates a cross-section view of the immersion cooling device 10 along the 6-6 cut line of Fig. 1. Fig. 7 illustrates a partially enlarged cross-section view of the immersion cooling device 10 shown in Fig. 1. The fins 123 of the fin portion 12 can each have a thickness T of 0.11 mm. Two consecutive fins 123 can have a spacing D3 of 0.11 mm. Of course, while in this exemplary embodiment the fins 123 are shown as having uniform spacing and thickness, it should be understood that many other configurations, such as non-uniform spacing or non-uniform thickness of the multiple fins 123, are also possible to accomplish the improved heat dissipation efficiency.

In one embodiment, as shown in Fig. 2, the immersion cooling device 10 can also include two side covers 14, and the covering portion 13 can include two processing channels 137 that connect to the internal circulation channel 133. The processing channels 137 can provide access for fabricating the internal circulation channel 133 during a fabricating process. The two side covers 14 can be used to cover the processing channels 137 to shield the internal circulation channel 133.

In one embodiment, the covering portion 13 can have a flat bottom surface where the microfluidic channels 135 and piercing structures 136 are disposed, instead of caving inward. The base portion 11 can be concaved inward from the heat dissipating surface 112 to accommodate the fin portion 12 and form the vapor chamber S with the covering portion 13.

In one embodiment, the first end 1332 of the internal circulation channel 133 can connect directly to the vapor chamber S without connect to the liquid inlet channel 131 first. In this way, the cooling fluid can flow into the vapor chamber S from the internal circulation channel.

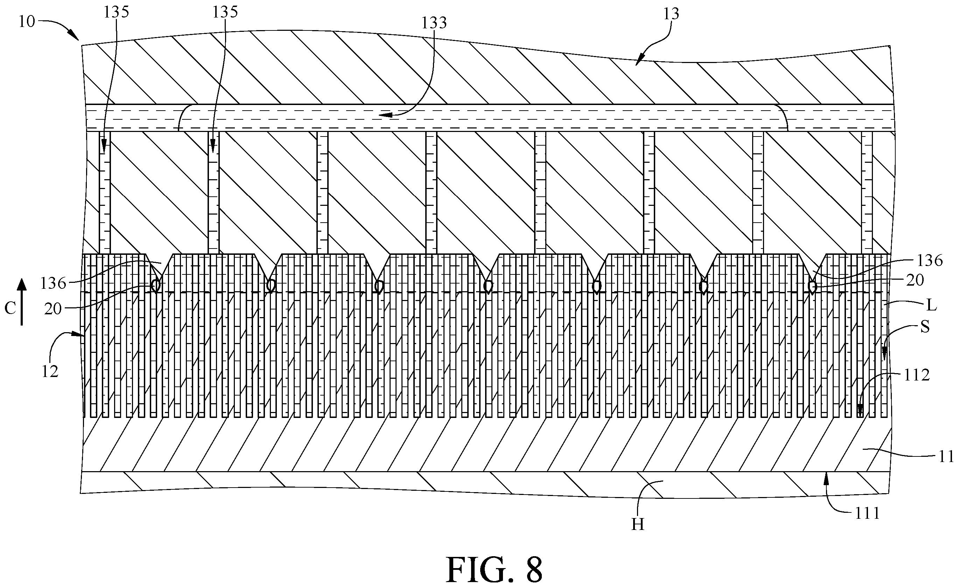

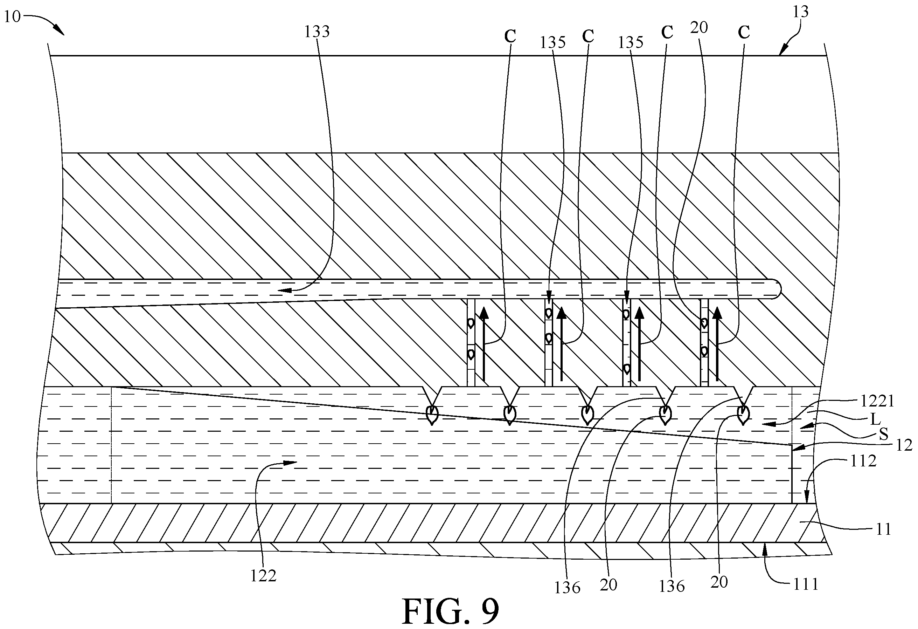

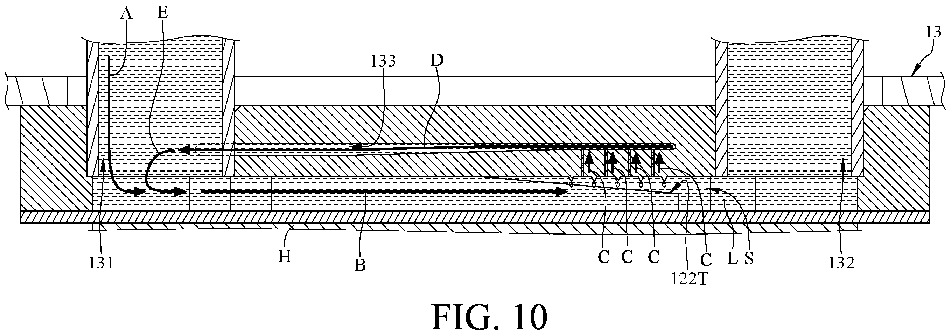

Further referring to Figs. 8 to 10. Fig. 8 illustrates a cross-section view of the vapor chamber S in Fig. 1 when the air bubbles are generated. Fig. 9 illustrates a cross-section view of the vapor chamber S when the air bubbles pierced and flowed into the microfluidic channel 135. Figure 10 illustrates a cross-section view the vapor chamber 10 and the flow of the cooling fluid vapor during operation of the immersion cooling device 10.

The immersion cooling device 10 is thermally coupled to a heat source H, and the heat generated by the heat source H is transmitted to the cooling fluid L through the heat-absorbing surface 111 and the heat dissipating surface 112. As shown in Fig. 10, the cooling fluid L can flow into the vapor chamber S from the liquid inlet channel 131 along a direction A. Then, the cooling fluid L can flow along a direction B in the vapor chamber S and absorbs the heat of the heat source H and vaporizes into gaseous vapor. The vapor can then flow into the internal circulation channel 133 through the microfluidic channels 135 along a direction C from the vapor chamber S. Then, the vapor can be cooled and condensed back into the cooling fluid L in the internal circulation channel 133 and flow along a direction D. The cooling fluid L can flow along a direction E back into the vapor chamber S through the liquid inlet channel 131. Therefore, the cooling cycle of the cooling fluid L to the heat source H can be completed.

Further, as shown in Fig. 10, the liquid cooling fluid L flows from the liquid inlet channel 131 in direction A into the vapor chamber S. Then, the liquid cooling fluid L flows in direction B in the vapor chamber S and absorbs the heat of the heat source H and vaporizes to produce a plurality of air bubbles 20. The air bubbles 20 accumulate when the operation time of the immersion cooling device 10 increases, resulting the volume of these bubbles 20 gradually increases, and floats up to the top side 122T of the outlet section 122 along direction C. Because of the configuration of the outlet section, the air bubbles 20 can exit the fin portion 12 in reduced time without causing blockage. This can reduce 80% of the accumulation of the air during the operation of the immersion cooling device 10, which can further reduce the resistance and pressure drop of the cooling fluid flow, thereby improving the heat dissipation efficiency.

The air bubbles 20 can then be pierced by the piercing structures 136 after floating into the cavity 1221, so that the air bubbles 20 can be dispersed into a plurality of smaller air bubbles 20. The smaller air bubbles 20 can flow into the internal circulation channel 133 through the microfluidic channels 135 along the direction C from the vapor chamber S. As shown in Fig. 9 and Fig. 10, these smaller air bubbles 20 can then be cooled and condensed into a liquid state in the internal circulation channel 133 and flow along the direction D. Lastly, the cooling fluid L can flow into the vapor chamber S from the internal circulation channel 133 through the liquid inlet channel 131 along the direction E. In this way, the cooling cycle of the cooling fluid L to the heat source H can be completed.

Fig. 11 illustrates a cross-section view of an immersion cooling device 10A according to a second embodiment of the present invention. The immersion cooling device 10A of the present embodiment is similar to the immersion cooling device 10 of the first embodiment, so the differences between the present embodiment and the first embodiment will be explained below, and the similarities will not be repeated. In the present embodiment, the outlet section 122A of the fin portion 12A can be a stepped structure.

Fig. 12 illustrates a cross-section view of an immersion cooling device 10B according to a third embodiment of the present invention. The immersion cooling device 10B of the present embodiment is similar to the immersion cooling device 10 of the first embodiment, so the differences between the present embodiment and the first embodiment will be explained below, and the similarities will not be repeated. In the present embodiment, the outlet section 122B of the fin portion 12B can be a composite of an inclined plane structure and a plurality of groove structures. In other embodiments, the outlet section may also be only a plurality of groove structures.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. An immersion cooling device (10, 10A, 10B) for dissipating heat, comprising:
a base portion (11) having a heat absorbing surface (111) and a heat dissipating surface (112);
a fin portion (12, 12A, 12B) that is arranged on the heat dissipating surface (112) of the base portion (11); and
a covering portion (13) having a vapor chamber (S) that is positioned around the fin portion (12, 12A, 12B) on the base, the covering portion (13) including a liquid inlet channel (131) and a liquid outlet channel (132),
wherein, the fin portion (12, 12A, 12B) includes an inlet section (121) that is located adjacent to the liquid inlet channel (131) and an outlet section (122, 122A, 122B) that is located adjacent to the liquid outlet channel (132), and the outlet section (122, 122A, 122B) is arranged so that a cavity (1221) is formed within the vapor chamber (S) over the outlet section (122, 122A, 122B) of the fin portion (12, 12A, 12B).

2. The immersion cooling device (10, 10A, 10B) of claim 1, wherein the outlet section (122, 122A, 122B) includes a first height (H1) at a first location towards the inlet section (121) and a second height (H2) at a second location adjacent to the inlet section (121), and the first height (H1) is smaller than the second height (H2).

3. The immersion cooling device (10, 10A, 10B) of claim 2, wherein the outlet section (122, 122A, 122B) has a planar surface that declines towards the heat dissipating surface (112) from the first height (H1) to the second height (H2).

4. The immersion cooling device (10, 10A, 10B) of claim 3, wherein the planar surface of the outlet section (122, 122A, 122B) has an incline angle of greater than 0.5 degree and smaller than 5 degrees.

5. The immersion cooling device (10, 10A, 10B) of one of claims 1 to 4, wherein the outlet section (122, 122A, 122B) has a ladder structure.

6. The immersion cooling device (10, 10A, 10B) of one of claim 1 to 4, wherein the outlet section (122, 122A, 122B) has a multi-groove structure or an inclined multi-groove structure.

7. The immersion cooling device (10, 10A, 10B) of one of claims 1 to 6 , wherein the outlet section (122, 122A, 122B) has a horizontal length of 17.5 mm, and the fin portion (12, 12A, 12B) has a horizontal length of 35 mm.

8. The immersion cooling device (10, 10A, 10B) of one of claims 1 to 7, wherein the fin portion (12, 12A, 12B) includes multiple fins (123) having a thickness of 0.11 mm and a spacing (D3) of 0.11 mm between each other.

9. The immersion cooling device (10, 10A, 10B) of one of claims 1 to 8, wherein the covering portion (13) includes an internal circulation channel (133) that extends from a first end (1332) to a second end (1333) that are connected to the vapor chamber (S) at a location adjacent to the inlet section (121) and a location adjacent to the outlet section (122, 122A, 122B), respectively.

10. The immersion cooling device (10, 10A, 10B) of claim 9, wherein the internal circulation channel (133) includes a bottom surface (1331) facing the heat dissipating surface (112), and a distance (D1) between the bottom surface at the first end (1332) and the heat dissipating surface (112) is greater than a distance (D2) between the bottom at the second end (1333) and the heat dissipating surface (112).

11. The immersion cooling device (10, 10A, 10B) of claim 9 or 10, wherein the covering portion (13) further includes an inner surface (134) and at least one microfluidic channel (135), the inner surface (134) faces the heat dissipating surface (112), the at least one microfluidic channel (135) is concave inward from the inner surface (134), the first end (1332) of the internal circulation channel (133) connects to the vapor chamber (S) at the location adjacent to the inlet section (121) via the liquid inlet channel (131), and the second end (1333) of the internal circulation channel (133) connects to the vapor chamber (S) at the location adjacent to the outlet section (122, 122A, 122B) via the at least one microfluidic channel (135).

12. The immersion cooling device (10, 10A, 10B) of claim 11, wherein the covering portion (13) further includes a plurality of piercing structures (136) adjacent to the at least one microfluidic channel (135), the plurality of piercing structures (136) protrudes from the inner surface (134) of the covering portion (13).

13. The immersion cooling device (10, 10A, 10B) of one of claims 9 to 12, further comprising a side cover (14), the covering portion (13) includes a at least one processing channel (137) connected to the internal circulation channel (133), and the at least one side cover (14) is configured to cover the at least one processing channel (137) at a side that is away from the internal circulation channel (133).

14. The immersion cooling device (10, 10A, 10B) of one of claims 1 to 13, wherein the cavity (1221) has a first volume (P1), the outlet section (122, 122A, 122B) has a second volume (P2), and a ratio between the first volume (P1) and the second volume (P2) is 1.213.
